# EUROPEAN PATENT APPLICATION

(11) **EP 1 670 045 A2**
(43) Date of publication of application: **14.06.2006**
(21) Application number: 05026719.4
(22) Date of filing: 07.12.2005
(51) Int. Cl.: H01L 21/28, H01L 21/336, H01L 29/51, H01L 29/78, G11C 11/34

(54) **Gate of a memory transistor with a ferroelectric layer and method of manufacturing the same**

(30) Priority: 07.12.2004 JP 2004354320
(71) Applicant: SEIKO EPSON CORPORATION, Shinjuku-ku, Tokyo 163-0811 (JP)
(72) Inventor: Kijima, Takeshi, Suwa-shi Nagano-ken 392-8502 (JP); Hamada, Yasuaki, Suwa-shi Nagano-ken 392-8502 (JP); Higuchi, Takamitsu, Suwa-shi Nagano-ken 392-8502 (JP)
(74) Representative: Hoffmann, Eckart

(57) **Abstract**

A transistor type ferroelectric memory includes a group-IV semiconductor layer (10), an oxide semiconductor layer (20) formed over the group-IV semiconductor layer, a ferroelectric layer (30) formed over the oxide semiconductor layer, a gate electrode (40) formed over the ferroelectric layer, and a source region (12) and a drain region (14) formed in the group-IV semiconductor layer.
The group-IV semiconductor layer (10) and the oxide semiconductor layer (20) form a pn junction with a depletion layer at the interface of both layers. By controlling the fixed changes individual in the oxide semiconductor layer (20), the current flow between source (12) and drain (14) can be switched on or off.

## Description

### BACKGROUND OF THE INVENTION

The present invention relates to a transistor type ferroelectric memory having a novel structure and a method of manufacturing the same.

As the structure of a one-transistor (1T) type ferroelectric random access memory (FeRAM), a metal-ferroelectric-semiconductor (MFS) structure, a metal-ferroelectric-insulator-semiconductor (MFIS) structure, and a metal-ferroelectric-metal-insulator-semiconductor (MFMIS) structure have been known. However, FeRAMs having these structures have many problems.

In the MFS structure, since the surface of a group-IV semiconductor substrate formed of silicon or germanium is easily oxidized, it is very difficult to form an oxide ferroelectric layer on the surface of the substrate. This prevents the MFS structure from being put into practical use. Specifically, when forming the oxide ferroelectric layer on the group-IV semiconductor (e.g. silicon) layer, undesirable film such as a silicon oxide film is formed at the interface between the silicon layer and the oxide ferroelectric layer. Since such a film has a low relative dielectric constant, the operating voltage for causing the polarization reversal of the oxide ferroelectric must be increased. Moreover, since electric charges are injected into the film due to occurrence of a trap level in the film, electric charges due to remanent polarization are lost, so that a sufficient polarization reversal does not occur.

Since the MFIS structure uses a silicon oxide layer as the insulating layer (I layer), the MFIS structure suffers from a problem similar to that of the MFS structure. Specifically, since silicon oxide has a low relative dielectric constant, the operating voltage for causing the polarization reversal of the oxide ferroelectric must be increased. Moreover, since electric charges are injected into the silicon oxide film due to occurrence of a trap level in the silicon oxide layer, electric charges due to remanent polarization are lost, so that a sufficient polarization reversal does not occur. Moreover, since the silicon oxide layer as the I layer is amorphous, it is very difficult to form an oxide ferroelectric having a crystal structure on the silicon oxide layer.

The MFMIS structure has an advantage over the MFIS structure in view of deposition of the oxide ferroelectric layer, since a metal layer such as a platinum layer having a relatively good affinity to the oxide ferroelectric in view of crystallinity is formed on the I layer. However, the MFMIS structure suffers from a problem similar to that of the MFIS structure due to the presence of the I layer.

The MFIS structure and the MFMIS structure having the I layer pose the following problem as a nonvolatile memory. In the MFIS structure and the MFMIS structure, the oxide ferroelectric layer (F layer) and the I layer (insulating layer) are capacitively coupled. Therefore, when writing data into the F layer by applying voltage, the applied voltage is distributed to the I layer and the F layer corresponding to the relative dielectric constant and the thickness so that electric charges are stored corresponding to the applied voltage. The polarization direction of the stored electric charges is the same as the applied voltage direction in the I layer and the F layer. However, when retaining the data without applying voltage, the metal layer (M layer) and the semiconductor layer (S layer) are short-circuited. In this case, since the polarization direction of the F layer is fixed by the remanent polarization, electric charges are induced in the I layer in an amount the same as that of the ferroelectric capacitor formed by the F layer, and the polarization direction of the electric charges is the reverse of that of the ferroelectric capacitor. Therefore, a large electric field in the opposite direction is applied to the ferroelectric capacitor from the capacitor formed by the I layer. As a result, the polarization direction of the F layer is reversed so that stored data is lost.

### SUMMARY

A transistor type ferroelectric memory according to a first aspect of the invention comprises:
a group-IV semiconductor layer;
an oxide semiconductor layer formed over the group-IV semiconductor layer;
a ferroelectric layer formed over the oxide semiconductor layer;
a gate electrode formed over the ferroelectric layer; and
a source region and a drain region formed in the group-IV semiconductor layer.

A method of manufacturing a transistor type ferroelectric memory according to a second aspect of the invention comprises:
forming an oxide semiconductor layer over a group-IV semiconductor layer;
forming a ferroelectric layer over the oxide semiconductor layer;
forming a gate electrode over the ferroelectric layer; and
forming a source region and a drain region in the group-IV semiconductor layer.

The invention may provide a transistor type ferroelectric memory having a novel structure and a method of manufacturing the same.

A transistor type ferroelectric memory according to one embodiment of the invention includes:
a group-IV semiconductor layer;
an oxide semiconductor layer formed over the group-IV semiconductor layer;
a ferroelectric layer formed over the oxide semiconductor layer;
a gate electrode formed over the ferroelectric layer; and
a source region and a drain region formed in the group-IV semiconductor layer.

According to the transistor type ferroelectric memory according to one embodiment of the invention, specific fixed charges can be induced in the oxide semiconductor layer by controlling the polarization direction of the ferroelectric layer. The size of the energy barrier in the depletion layer formed at the interface between the group-IV semiconductor layer and the oxide semiconductor layer can be changed by controlling the fixed charges induced in the oxide semiconductor layer. Therefore, current flows between the source region and the drain region by causing the energy barrier in the depletion layer to become smaller than the potential difference between the source region and the drain region, so that the transistor type ferroelectric memory can be turned ON. Current does not flow between the source region and the drain region by causing the energy barrier in the depletion layer to become larger than the potential difference between the source region and the drain region, so that the transistor type ferroelectric memory can be turned OFF. The transistor type ferroelectric memory according to one embodiment of the invention can function as a nonvolatile memory by detecting the ON state and the OFF state. The operation of the transistor type ferroelectric memory according to one embodiment of the invention is described later.

With the transistor type ferroelectric memory according to this embodiment, the group-IV semiconductor layer and the oxide semiconductor layer may form a pn junction.

Since the group-IV semiconductor layer and the oxide semiconductor layer form the pn junction, a depletion layer is formed at the interface between the group-IV semiconductor layer and the oxide semiconductor layer. The pn junction is formed when the group-IV semiconductor layer is a p-type and the oxide semiconductor layer is an n-type and when the group-IV semiconductor layer is an n-type and the oxide semiconductor layer is a p-type.

With the transistor type ferroelectric memory according to this embodiment, one end of the source region and the drain region may be in contact with a part of the oxide semiconductor layer.

According to this configuration, electric charges (carriers) move more smoothly between the group-IV semiconductor layer and the oxide semiconductor layer.

With the transistor type ferroelectric memory according to this embodiment, the oxide semiconductor layer of an n-type may include at least one oxide semiconductor selected from ZnO, TiO₂, SnO₂, CdO, MnO, and FeO.

With the transistor type ferroelectric memory according to this embodiment, the oxide semiconductor layer of a p-type may include at least one oxide semiconductor selected from CuAlO₂, NiO, CoO, Cu₂O, MnFe₂O₄, NiFe₂O₄, In₂O₃, MnO, and FeO.

With the transistor type ferroelectric memory according to this embodiment, the ferroelectric layer may include a perovskite oxide or a bismuth layer-structured oxide shown by ABO₃ or (Bi₂O₂)²⁺(Aₘ₋₁BₘO₃ₘ₊₁)²⁻ (wherein A represents at least one element selected from Li, Na, K, Rb, Pb, Ca, Sr, Ba, Bi, La, and Hf, B represents at least one element selected from Ru, Fe, Ti, Zr, Nb, Ta, V, W, and Mo, and m is a natural number of 5 or less), or an oxide having a tungsten bronze structure shown by A_{0.5}BO₃ (tetragonal bronze structure) or A_{0.3}BO₃ (hexagonal bronze structure) (wherein A represents at least one element selected from Li, Na, K, Rb, Cs, Pb, Ca, Sr, Ba, Bi, and La, and B represents at least one element selected from Ru, Fe, Ti, Zr, Nb, Ta, V, W, and Mo).

With the transistor type ferroelectric memory according to this embodiment, the oxide semiconductor layer may include a dopant having a valence differing from a valence of a metal element forming the oxide semiconductor layer and functioning as a donor or an acceptor.

The carrier mobility can be increased due to the presence of such a dopant, whereby the operation speed can be increased.

Specifically, when a metal having a valence greater than that of a metal forming the oxide semiconductor is doped into the oxide semiconductor which tends to become an n-type, the metal functions as a donor. For example, when using TiO₂ as the oxide semiconductor, Nb or Ta may be used as the donor. When using ZnO as the oxide semiconductor, Al may be used as the donor. When using BaTiO₃ as the oxide semiconductor, La or Ta may be used as the donor. When using SnO₂ as the oxide semiconductor, Sb may be used as the donor.

When a metal having a valence smaller than that of a metal forming the oxide semiconductor is doped into the oxide semiconductor which tends to become a p-type, the metal functions as an acceptor. For example, when using NiO, CoO, FeO, or MnO as the oxide semiconductor, Li may be used as the acceptor. When using Bi₂O₃ as the oxide semiconductor, Ba may be used as the acceptor. When using Cr₂O₃ as the oxide semiconductor, Mg may be used as the acceptor. When using LaCrO₃ as the oxide semiconductor, Sr may be used as the acceptor.

A method of manufacturing a transistor type ferroelectric memory according to one embodiment of the invention includes:
forming an oxide semiconductor layer over a group-IV semiconductor layer;
forming a ferroelectric layer over the oxide semiconductor layer;
forming a gate electrode over the ferroelectric layer; and
forming a source region and a drain region in the group-IV semiconductor layer.

With the method of manufacturing a transistor type ferroelectric memory according to this embodiment,
the group-IV semiconductor layer and the oxide semiconductor layer may have opposite polarities and form a pn junction.

The pn junction is formed when the group-IV semiconductor layer is a p-type and the oxide semiconductor layer is an n-type and when the group-IV semiconductor layer is an n-type and the oxide semiconductor layer is a p-type.

The method of manufacturing a transistor type ferroelectric memory according to this embodiment may include:
before forming the oxide semiconductor layer, forming a film of an element having an enthalpy of formation smaller (enthalpy of formation larger in the negative direction) than that of an oxide of an element forming the group-IV semiconductor layer on a surface of the group-IV semiconductor layer under non-oxidizing conditions.

For example, when using a silicon layer or a silicon substrate as the group-IV semiconductor layer, a layer of a metal element having an enthalpy of formation smaller than that of silicon oxide (hereinafter may be called "underlayer") may be formed on the group-IV semiconductor layer under non-oxidizing conditions, and the oxide semiconductor layer may be formed thereafter.

An oxide film of an element (e.g. silicon) forming the group-IV semiconductor layer can be prevented from being formed on the surface of the group-IV semiconductor layer by forming such an underlayer. Therefore, an adverse effect caused by a dielectric film such as a silicon oxide layer, which poses a problem in a related-art FeRAM, can be prevented.

As the element forming the underlayer, it is preferable to use an element which functions as a donor or an acceptor in the oxide semiconductor layer.

Embodiments of the invention are described below in detail with reference to the drawings.

### BRIEF DESCRIPTION OF THE SEVERAL VIEWS OF THE DRAWING

- FIG. 1: is a cross-sectional diagram showing a transistor type ferroelectric memory according to one embodiment of the invention.
- FIG. 2: is a cross-sectional diagram showing another transistor type ferroelectric memory according to one embodiment of the invention.
- FIG. 3: is a diagram showing the operation of the transistor type ferroelectric memory shown in FIG. 1.
- FIG. 4: is a diagram showing the operation of the transistor type ferroelectric memory shown in FIG. 1.
- FIG. 5: is a diagram showing the operation of the transistor type ferroelectric memory shown in FIG. 2.
- FIG. 6: is a diagram showing the operation of the transistor type ferroelectric memory shown in FIG. 2.
- FIG. 7: is an energy band diagram of the transistor type ferroelectric memory shown in FIG. 1.

- FIG. 8: is an energy band diagram of the transistor type ferroelectric memory shown in FIG. 1.
- FIG. 9: is a diode C-V characteristic diagram of a sample of Example 1.
- FIG. 10: is a diode data retention characteristic diagram of the sample of Example 1.
- FIG. 11: is a diode C-V characteristic diagram of a sample of Example 2.
- FIG. 12: is a diode data retention characteristic diagram of the sample of Example 2.
- FIG. 13: is a cross-sectional diagram showing the structure of a sample of Comparative Example 1.
- FIG. 14: is a diode C-V characteristic diagram of the sample of Comparative Example 1.

### DETAILED DESCRIPTION OF THE EMBODIMENT

### 1. Transistor Type Ferroelectric Memory

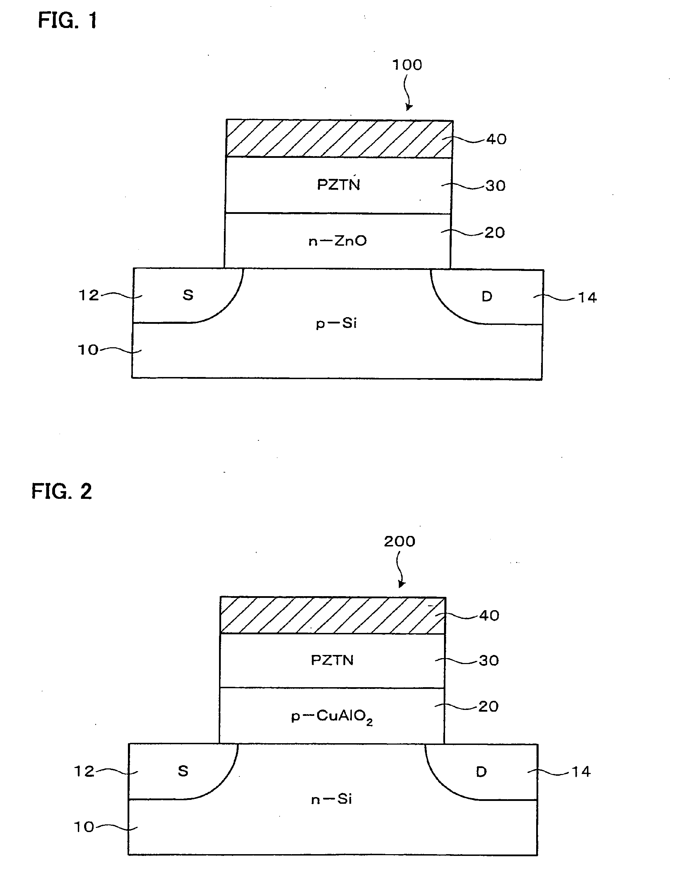

FIG. 1 is a cross-sectional diagram schematically showing an example of a transistor type ferroelectric memory 100 according to one embodiment of the invention.

The transistor type ferroelectric memory 100 includes a group-IV semiconductor layer 10, an oxide semiconductor layer 20 formed on the group-IV semiconductor layer 10, a ferroelectric layer 30 formed on the oxide semiconductor layer 20, and a gate electrode 40 formed on the ferroelectric layer. The group-IV semiconductor layer 10 and the oxide semiconductor layer 20 form a pn junction. In the example shown in FIG. 1, the group-IV semiconductor layer is a p-type, and the oxide semiconductor layer is an n-type. The group-IV semiconductor layer 10 is a layer formed of a group-IV semiconductor such as silicon or germanium. A silicon substrate is used in the example shown in FIG. 1.

A source region 12 and a drain region 14 are formed in the group-IV semiconductor layer 10. The oxide semiconductor layer 20, the ferroelectric layer 30, and the gate electrode 40 are layered on the group-IV semiconductor layer 10 in that order.

Each end of the bottom surface of the oxide semiconductor layer 20 is formed to overlap the end of the source region 12 or the drain region 14. Specifically, one end of the oxide semiconductor layer 20 is in contact with the end of source region 12, and the other end of the oxide semiconductor layer 20 is in contact with the end of the drain region. According to this configuration, electric charges (carriers) move more smoothly between the group-IV semiconductor layer 10 and the oxide semiconductor layer 20.

The material for the n-type oxide semiconductor layer 20 is not particularly limited. Any of the above-mentioned materials may be used. In the example shown in FIG. 1, the oxide semiconductor layer 20 is formed of ZnO.

The thickness of the oxide semiconductor layer 20 may be set without taking the relative dielectric constant into consideration, differing from a dielectric. The thickness of the oxide semiconductor layer 20 is preferably 100 nm or less in practical application. When a high-speed operation is desired for a transistor, the thickness of the oxide semiconductor layer 20 is set at 3 nm or less. This causes a tunneling current to occur, so that it is unnecessary to take the mobility of the oxide semiconductor into consideration.

The material for the ferroelectric layer 30 is not particularly limited. Any of the above-mentioned materials may be used. In the example shown in FIG. 1, the ferroelectric layer 30 is formed of PZTN.

It suffices that the ferroelectric layer 30 have a thickness acceptable in practical application. When causing the polarization reversal to occur at a low voltage of 3 V or less, it is preferable that the ferroelectric layer 30 have a thickness of 200 nm or less.

The material for the gate electrode 40 is not particularly limited. The material for the gate electrode 40 is appropriately selected depending on the material and the deposition method for the ferroelectric layer 30, for example. As examples of the material for the gate electrode 40, platinum elements such as platinum and iridium, oxides such as IrO₂ and InO₂, perovskite oxides such as LaNiO₃, and the like can be given.

FIG. 2 is a cross-sectional diagram showing an example of another transistor type ferroelectric memory 200 according to one embodiment of the invention.

In this example, the pn junction formed by the group-IV semiconductor layer 10 and the oxide semiconductor layer 20 differs from that of the example shown in FIG. 1. Specifically, the group-IV semiconductor layer 10 is an n-type and the oxide semiconductor layer 20 is a p-type. The other configuration is the same as the configuration of the transistor type ferroelectric memory 100 shown in FIG. 1.

The material for the p-type oxide semiconductor layer 20 is not particularly limited. Any of the above-mentioned materials may be used. In the example shown in FIG. 1, the oxide semiconductor layer 20 is formed of CuAlO₂.

The operation of the transistor type ferroelectric memory according to one embodiment of the invention is described below.

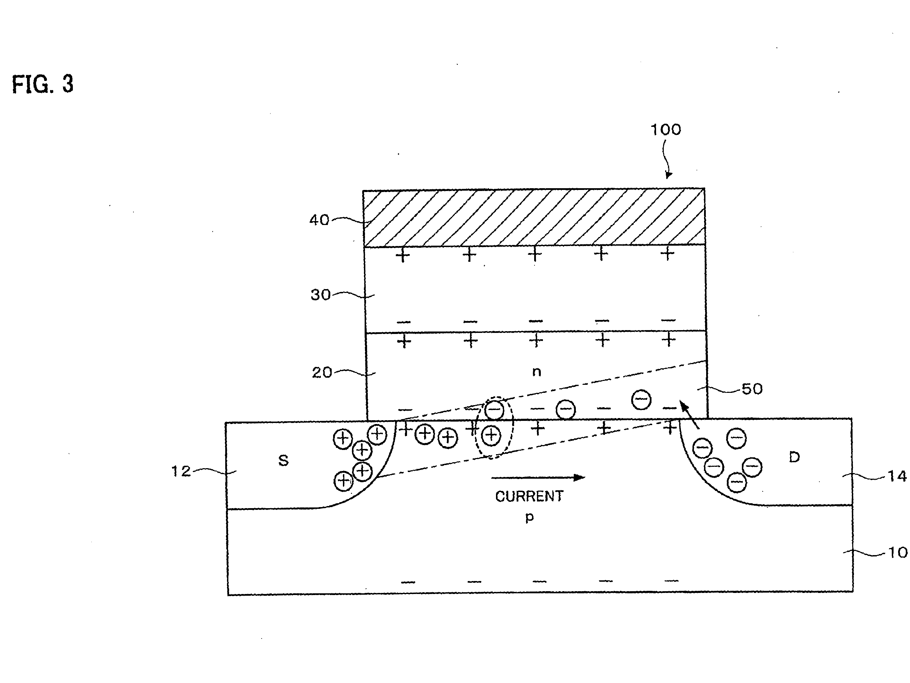

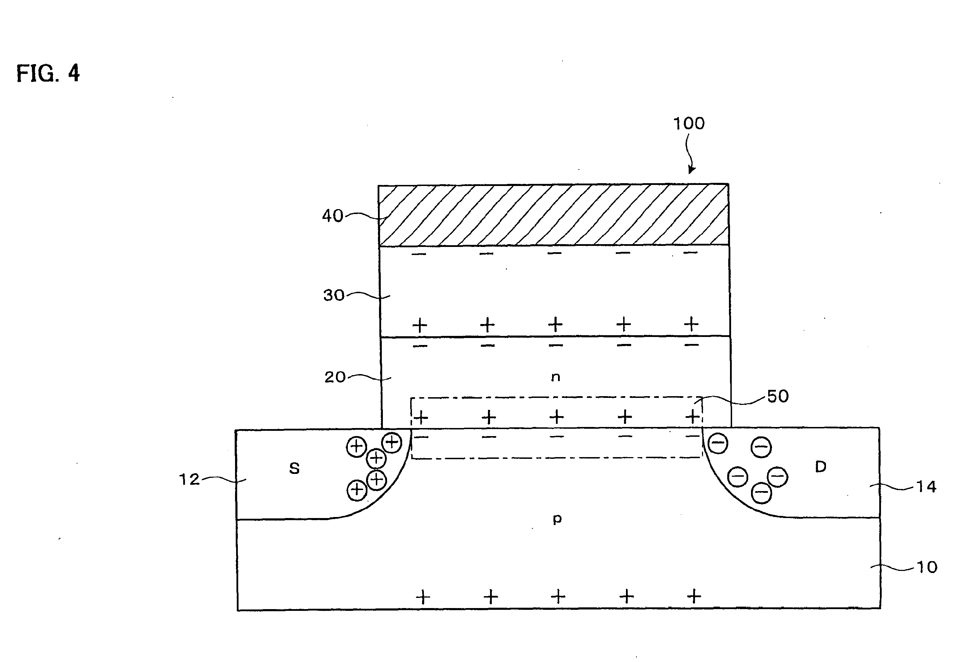

FIGS. 3 and 4 are diagrams showing the operation of the transistor type ferroelectric memory shown in FIG. 1.

FIG. 3 schematically shows the case where current flows between the source region 12 and the drain region 14. In this case, an upward polarization occurs in the ferroelectric layer 30. For example, when a negative voltage (-V) sufficient to cause the polarization reversal of the ferroelectric is applied to the gate electrode 40 and 0 V is then applied to the gate electrode 40, an upward polarization occurs in the ferroelectric layer 30. Since the oxide semiconductor layer 20 has a low relative dielectric constant, an upward polarization also occurs in the oxide semiconductor layer 20 in the same manner as in the ferroelectric layer 30. Specifically, in the vicinity of the pn junction formed by the p-type group-IV semiconductor layer 10 and the n-type oxide semiconductor layer 20, negative fixed charges are induced on the side of the oxide semiconductor layer 20, and positive fixed charges are induced on the side of the group-IV semiconductor layer 10. This reduces the energy barrier in a depletion layer 50 formed at the pn junction. As a result, since the potential difference between the source region 12 and the drain region 14 becomes larger than the energy barrier in the depletion layer 50, electric charges (carriers) recombine at the pn junction, so that current flows between the source region and the drain region.

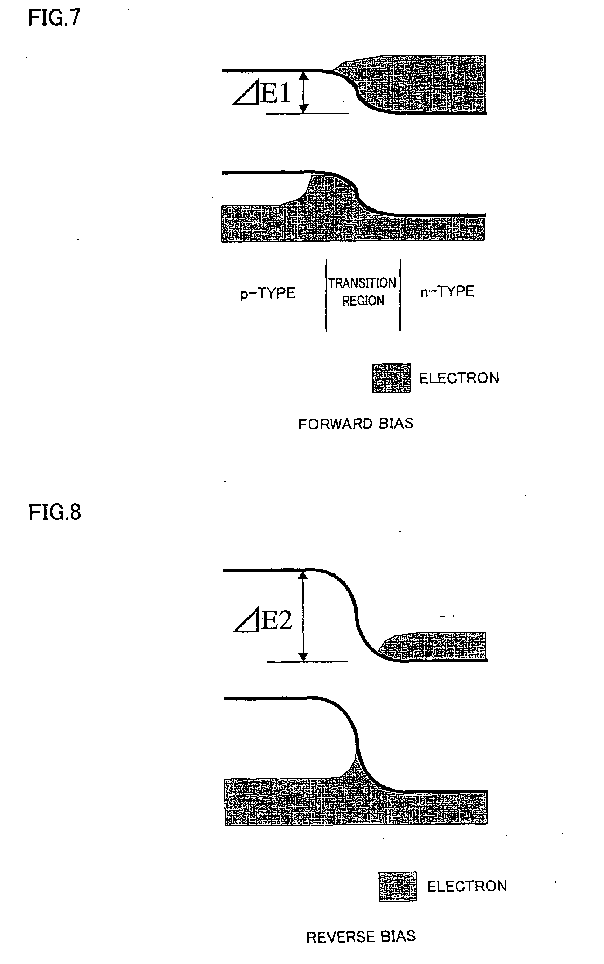

FIG. 7 is the energy band diagram in this state. When an upward polarization occurs in the ferroelectric layer 30 as shown in FIG. 3, the energy barrier is reduced to ΔE1 corresponding to the storage volume of the negative fixed charges induced on the side of the oxide semiconductor layer 20 at the pn junction formed by the oxide semiconductor layer 20 and the group-IV semiconductor layer 10. When holes are introduced from the source region and electrons are introduced from the drain region, the holes and electrons overcome the energy barrier and recombine at the pn junction, so that current flows from the source region to the drain region.

FIG. 4 schematically shows the case where current does not flow between the source region and the drain region. In this case, a downward polarization occurs in the ferroelectric layer 30. For example, when a positive voltage (+V) sufficient to cause the polarization reversal of the ferroelectric is applied to the gate electrode 40 and 0 V is then applied to the gate electrode 40, a downward polarization occurs in the ferroelectric layer 30. Since the oxide semiconductor layer 20 has a low relative dielectric constant, a downward polarization also occurs in the oxide semiconductor layer 20 in the same manner as in the ferroelectric layer 30. Specifically, in the vicinity of the pn junction formed by the group-IV semiconductor layer 10 and the oxide semiconductor layer 20, positive fixed charges are induced on the side of the oxide semiconductor layer 20, and negative fixed charges are induced on the side of the group-IV semiconductor layer 10. This increases the energy barrier in the depletion layer 50 formed at the pn junction. As a result, since the potential difference between the source region 12 and the drain region 14 becomes smaller than the energy barrier in the depletion layer 50, recombination of electric charges (carriers) does not occur at the pn junction, so that current does not flow between the source region and the drain region.

FIG. 8 is the energy band diagram in this state. When a downward polarization occurs in the ferroelectric layer 30 as shown in FIG. 4, the energy barrier is increased to ΔE2 corresponding to the storage volume of the positive fixed charges induced on the side of the oxide semiconductor layer 20 at the pn junction formed by the oxide semiconductor layer 20 and the group-IV semiconductor layer 10. Therefore, even when holes are introduced from the source region and electrons are introduced from the drain region, the holes and electrons cannot overcome the energy barrier due to the reverse bias state and cannot recombine at the pn junction, so that current does not flow from the source region to the drain region.

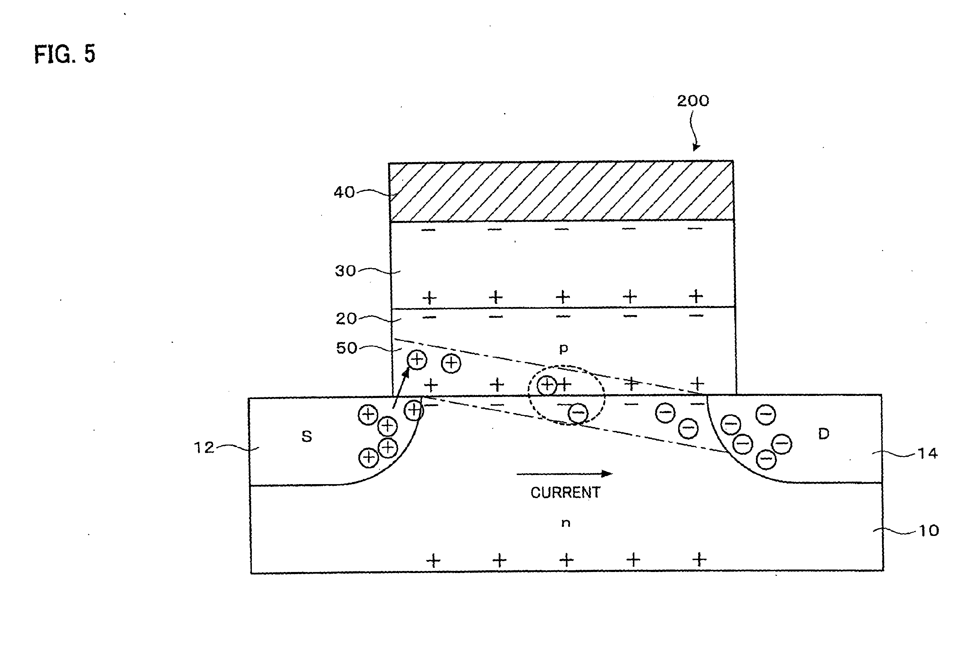

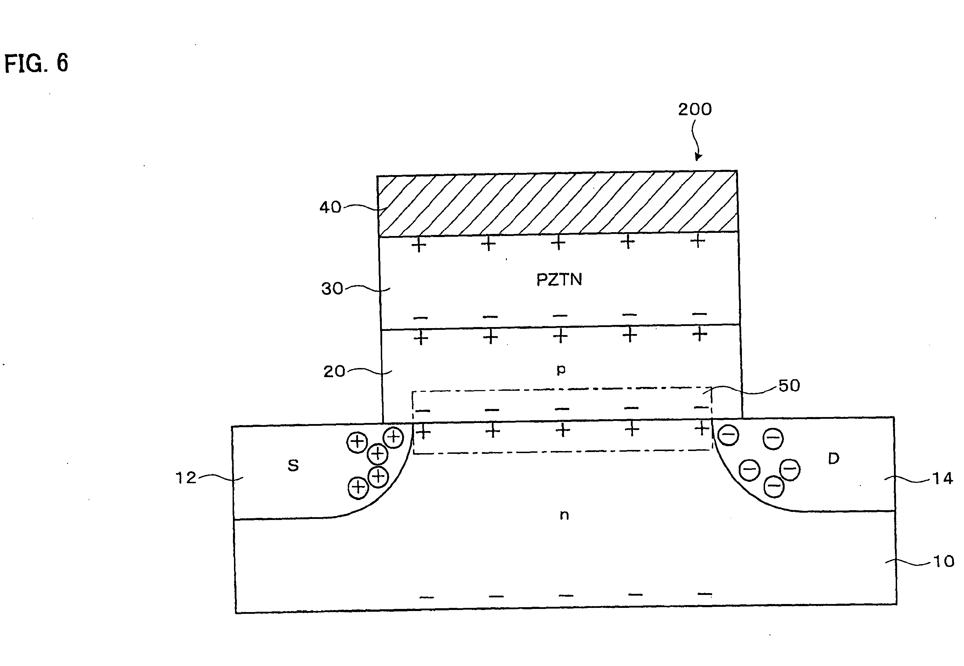

FIGS. 5 and 6 are diagrams showing the operation of the transistor type ferroelectric memory 200 shown in FIG. 2. The operation of the transistor type ferroelectric memory 200 is basically the same as the operation of the transistor type ferroelectric memory 100.

FIG. 5 schematically shows the case where current flows between the source region 12 and the drain region 14. In this case, a downward polarization occurs in the ferroelectric layer 30. For example, when a positive voltage (+V) sufficient to cause the polarization reversal of the ferroelectric is applied to the gate electrode 40 and 0 V is then applied to the gate electrode 40, a downward polarization occurs in the ferroelectric layer 30. Since the oxide semiconductor layer 20 has a low relative dielectric constant, a downward polarization also occurs in the oxide semiconductor layer 20 in the same manner as in the ferroelectric layer 30. Specifically, in the vicinity of the pn junction formed by the n-type group-IV semiconductor layer 10 and the p-type oxide semiconductor layer 20, positive fixed charges are induced on the side of the oxide semiconductor layer 20, and negative fixed charges are induced on the side of the group-IV semiconductor layer 10. This reduces the energy barrier in the depletion layer 50 formed at the pn junction. As a result, since the potential difference between the source region 12 and the drain region 14 becomes larger than the energy barrier in the depletion layer 50, holes and electrons recombine at the pn junction, so that current flows from the source region 12 to the drain region 14.

FIG. 6 schematically shows the case where current does not flow between the source region 12 and the drain region 14. In this case, an upward polarization occurs in the ferroelectric layer 30. For example, when a negative voltage (-V) sufficient to cause polarization reversal of the ferroelectric is applied to the gate electrode 40 and 0 V is then applied to the gate electrode 40, an upward polarization occurs in the ferroelectric layer 30. Since the oxide semiconductor layer 20 has a low relative dielectric constant, an upward polarization also occurs in the oxide semiconductor layer 20 in the same manner as in the ferroelectric layer 30. Specifically, in the vicinity of the pn junction formed by the n-type group-IV semiconductor layer 10 and the p-type oxide semiconductor layer 20, negative fixed charges are induced on the side of the oxide semiconductor layer 20, and positive fixed charges are induced on the side of the group-IV semiconductor layer 10. This increases the energy barrier in the depletion layer 50 formed at the pn junction. Therefore, the potential difference between the source region 12 and the drain region 14 becomes smaller than the energy barrier in the depletion layer 50. As a result, even when holes are introduced from the source region 12 and electrons are introduced from the drain region 14, the holes and electrons cannot overcome the energy barrier due to the reverse bias state and cannot recombine at the pn junction, so that current does not flow from the source region 12 to the drain region 14.

As described above, current flows between the source region 12 to the drain region 14 by causing the energy barrier in the depletion layer to become smaller than the potential difference between the source region 12 and the drain region 14, so that the transistor type ferroelectric memory is turned ON. Current does not flow between the source region 12 to the drain region 14 by causing the energy barrier in the depletion layer to become larger than the potential difference between the source region 12 and the drain region 14, so that the transistor type ferroelectric memory is turned OFF.

Therefore, data stored in the transistor type ferroelectric memory according to one embodiment of the invention is not destroyed during reading by detecting the ON state and the OFF state, that is, detecting one polarization state as "0" and the other polarization state as "1".

According to one embodiment of the invention, a transistor type ferroelectric memory which functions as a nondestructive read type nonvolatile memory can be provided by using a completely novel structure and operation.

According to the transistor type ferroelectric memory according to one embodiment of the invention, since the group-IV semiconductor layer 10 and the oxide semiconductor layer 20 are oxide crystals, an excellent interface can be obtained.

According to the transistor type ferroelectric memory according to one embodiment of the invention, since the transistor can be turned ON or OFF by utilizing the energy barrier in the depletion layer at the pn junction formed by the group-IV semiconductor layer 10 and the oxide semiconductor layer 20, the material for the ferroelectric layer can be selected from a wide range of materials.

Moreover, a high-speed operation is enabled regardless of the mobility of the oxide semiconductor by setting the thickness of the oxide semiconductor layer 20 at a physical film thickness at which a tunneling current occurs (i.e. 3 nm or less).

### 2. Method of Manufacturing Transistor Type Ferroelectric Memory

A method of manufacturing a transistor type ferroelectric memory according to one embodiment of the invention may include the following steps. The manufacturing method is described below with reference to FIGS. 1 and 2.

### (a) Formation of oxide semiconductor layer 20 over group-IV semiconductor layer 10

The oxide semiconductor layer 20 is formed over the group-IV semiconductor layer 10 such as a silicon substrate by using a method such as laser ablation, RF sputtering, DC sputtering, or deposition. The group-IV semiconductor layer 10 and the oxide semiconductor layer 20 are formed to have opposite polarities and form a pn junction. In more detail, as shown in FIG. 1, when the group-IV semiconductor layer 10 is a p-type, the oxide semiconductor layer 20 is an n-type. As shown in FIG. 2, when the group-IV semiconductor layer 10 is an n-type, the oxide semiconductor layer 20 is a p-type. The polarity of the oxide semiconductor layer 20 may be specified by the type of the oxide semiconductor forming the oxide semiconductor layer 20 or the type of the donor or acceptor doped into the oxide semiconductor layer 20.

As the n-type oxide semiconductor, the p-type oxide semiconductor, and the donor and the acceptor as the dopants, the above-mentioned materials may be used.

Before forming the oxide semiconductor layer 20, it is preferable to form a layer of an element having an enthalpy of formation smaller than that of an oxide of an element forming the group-IV semiconductor layer 10 on the surface of the group-IV semiconductor layer 10 under non-oxidizing conditions. For example, when the group-IV semiconductor layer is formed of silicon, a layer (underlayer) of a metal element having an enthalpy of formation smaller than that of silicon oxide is formed on the group-IV semiconductor layer 10 under non-oxidizing conditions. The term "under non-oxidizing conditions" used herein means that the underlayer is deposited in an atmosphere which does not contain oxygen.

It suffices that the underlayer be able to prevent the group-IV semiconductor layer 10 from contacting oxygen. The underlayer has a thickness of 3 to 50 nm, for example. As the deposition method for the underlayer, a method the same as the deposition method for the oxide semiconductor layer 20 may be used.

An oxide film of the element (e.g. silicon) forming the group-IV semiconductor layer 10 can be prevented from being formed on the surface of the group-IV semiconductor layer 10 by forming such an underlayer. Therefore, an adverse effect caused by a dielectric film such as a silicon oxide layer, which poses a problem in a related-art 1T type FeRAM, can be eliminated.

As the element forming the underlayer, it is preferable to use an element which functions as a donor or an acceptor in the oxide semiconductor layer. The mobility of the oxide semiconductor can be improved by using the underlayer formed of such an element. Moreover, when forming the oxide semiconductor layer 20 in an oxygen atmosphere, a metal having an enthalpy of oxide formation smaller than that of silicon is easily oxidized in comparison with silicon. Therefore, the metal reduces the SiO₂ film originally formed on the surface of the silicon substrate to separate the SiO₂ film into silicon and oxygen, and the metal forms an oxide together with the separated oxygen, whereby an excellent interface with the silicon substrate can be formed.

As examples of the metal having an enthalpy of oxide formation smaller than that of silicon (metal having a larger enthalpy of formation in the negative direction), the following elements can be given. As a group 3a element, Y can be given. As a group 3b element, Al, B, Ga, and In can be given. As a group 4a element, Ti can be given. As a group 5a element, Nb, Ta, and V can be given. As a group 5b element, Sb can be given. As a group 6a element, Cr can be given. As a group 7a element, Mn can be given. As a group 8 element, Fe can be given. As a lanthanoide series element, Ce, Er, Eu, Gd, La, and Nd can be given.

### (b) Formation of ferroelectric layer over oxide semiconductor layer

The ferroelectric layer 30 is formed over the oxide semiconductor layer 20. The material for the ferroelectric layer is not particularly limited. Any of the above-mentioned materials may be used.

As the ferroelectric, PZTN proposed by the inventor of the invention (JP-A-2005-100660) may also be used. PZTN is shown by Pb(Zr,Ti,Nb)O₃, in which Nb is preferably included at a ratio of 0.05 to 0.3 with respect to Zr and Ti in total. The ferroelectric PZTN may include Si or Si and Ge preferably in an amount of 0.5 to 5 mol%.

The PZTN ferroelectric layer may be obtained by providing a mixed solution of first to third raw material solutions, each containing at least one of Pb, Zr, Ti, and Nb, and crystallizing oxides contained in the mixed solution by a heat treatment or the like. As the first raw material solution, a solution in which a polycondensation product for forming a PbZrO₃ perovskite crystal formed by Pb and Zr among the constituent metal elements of the PZTN ferroelectric phase is dissolved in a solvent such as n-butanol in an anhydrous state can be given. As the second raw material solution, a solution in which a polycondensation product for forming a PbTiO₃ perovskite crystal formed by Pb and Ti among the constituent metal elements of the PZTN ferroelectric phase is dissolved in a solvent such as n-butanol in an anhydrous state can be given. As the third raw material solution, a solution in which a polycondensation product for forming a PbNbO₃ perovskite crystal formed by Pb and Nb among the constituent metal elements of the PZTN ferroelectric phase is dissolved in a solvent such as n-butanol in an anhydrous state can be given.

A capacitor using PZTN as the ferroelectric exhibits excellent hysteresis characteristics and shows only a small amount of leakage current. Therefore, PZTN is useful as the ferroelectric according to one embodiment of the invention.

The ferroelectric layer may be formed by using a known method such as a sol-gel method, a CVD method, a sputtering method, or liquid source misted chemical deposition (LSMCD).

### (c) Formation of gate electrode on ferroelectric layer

The gate electrode 40 is formed over the ferroelectric layer 30. The material for the gate electrode 40 is not particularly limited. The material for the gate electrode 40 may be selected depending on the type of ferroelectric, the deposition method for the gate electrode, and the like. As the gate electrode, the above-mentioned platinum metal such as platinum or iridium may be used, for example.

The oxide semiconductor layer 20, the ferroelectric layer 30, and the gate electrode 40 are deposited in layers, and patterned by etching using lithography or the like.

### (d) Formation of source region and drain region in group-IV semiconductor layer

The source region 12 and the drain region 14 are formed by introducing p-type or n-type impurities into the group-IV semiconductor layer 10 by ion implantation using the gate electrode 40 as a mask, in the same manner as a source region and a drain region of a MOS transistor.

According to the method of manufacturing a transistor type ferroelectric memory according to one embodiment of the invention, since the group-IV semiconductor layer 10 and the oxide semiconductor layer 20 are oxide crystals, an excellent interface can be formed.

### 3. Example

### 3.1 Example 1

In Example 1, a transistor type ferroelectric memory (1T type FeRAM) having a Pt/PZTN/n-ZnO/p-Si structure, as shown in FIG. 1, was formed.

An Mg layer having a thickness of about 5 nm was formed on a silicon substrate at a substrate temperature of 350°C by using a laser abrasion method. An MgO layer having a thickness of 20 nm was grown on the Mg layer at a substrate temperature of 350°C by using a laser abrasion method. A ZnO layer having a thickness of 50 nm was formed on the MgO layer at a substrate temperature of 600°C by using a laser abrasion method. As a result, an excellent ZnO layer was formed. It was confirmed that MgO having an enthalpy of formation of -600 kJ/mol, which is smaller than that of ZnO (enthalpy of formation: -350.5 kJ/mol), exhibits the effect of protecting the surface of the silicon substrate from oxidation. This is because the surface of the silicon substrate was protected from oxygen by coating the surface of the silicon substrate with the Mg layer before growth of the oxide semiconductor.

A Pb(Zr,Ti,Nb)O₃ ferroelectric layer was formed on the ZnO layer by using a sol-gel method. In more detail, a PbZr_{0.25}Ti_{0.55}Nb_{0.2}O₃ layer having a thickness of 120 nm was formed at a firing temperature of 650°C by using a PbZr_{0.25}Ti_{0.55}Nb_{0.2}O₃ formation sol-gel solution containing 15% excess Pb.

A platinum gate electrode having a thickness of 100 nm was formed on the ferroelectric layer by using a sputtering method.

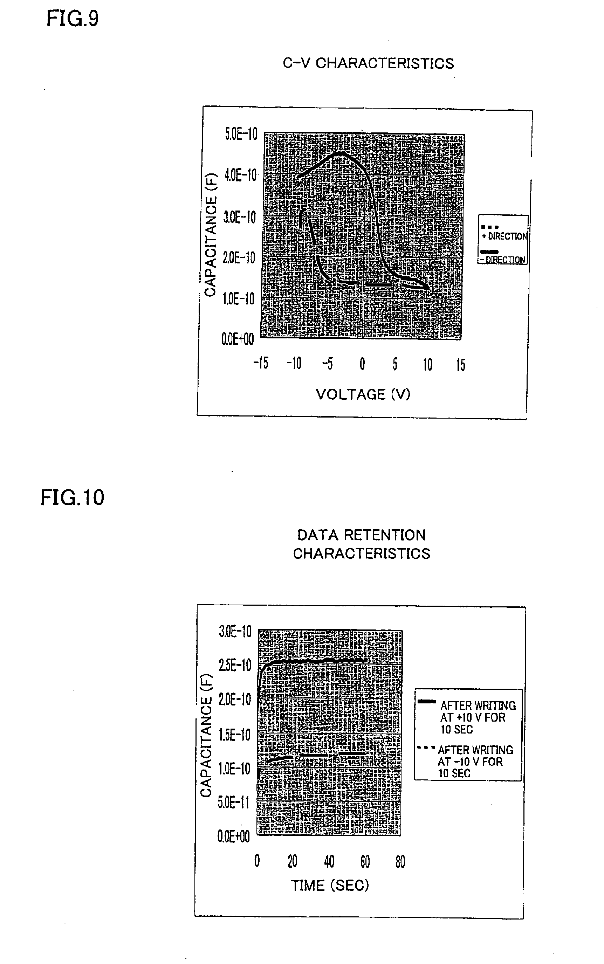

The C-V characteristics of the diode between the gate electrode and the silicon substrate were determined for the resulting sample to obtain the results shown in FIG. 9. As shown in FIG. 9, a C-V hysteresis curve having two threshold values was obtained due to the hysteresis of the ferroelectric. Since two values were obtained at a voltage of 0 V in the C-V hysteresis curve shown in FIG. 9, the retention characteristics of the two values were examined. The data retention characteristics were examined by writing data into the sample by applying an electric charge in the positive direction and measuring a change in the amount of stored charge at 0 V, and then writing data into the sample by applying an electric charge in the negative direction and measuring a change in the amount of stored charge at 0 V. The results are shown in FIG. 10. As shown in FIG. 10, it was confirmed that excellent data retention characteristics are obtained for the two values.

As a reference, the oxide semiconductor layer was formed by using the following method. As a result, an oxide semiconductor layer exhibiting excellent properties could not be obtained. After removing a native oxide film on the p-type silicon substrate by using hydrofluoric acid, the ZnO layer was formed by using a laser abrasion method. As a result, since SiO₂ was initially formed on the surface of the silicon substrate, it was difficult to crystallize ZnO. The reason that the surface of the silicon substrate is easily oxidized in the ZnO growth process can be explained by the difference in standard enthalpy of formation between ZnO and SiO₂. Specifically, while the enthalpy of formation of SiO₂ is -920.7 kJ/mol, the enthalpy of formation of ZnO is -350.5 kJ/mol. Therefore, Si is easily oxidized in comparison with Zn. This causes the surface of Si to be initially oxidized so that ZnO was not crystallized.

### 3.2 Example 2

In Example 2, a 1T type FeRAM having a Pt/PZTN/p-CuAlO₂/n-Si structure was formed. An Al layer having a thickness of 30 nm was formed on a silicon substrate by deposition. A Cu layer having a thickness of 30 nm was formed on the Al layer by deposition. A Pb(Zr,Ti,Nb)O₃ ferroelectric layer was formed on the Cu layer by using a sol-gel method. In more detail, a film was formed by a spin coating method using a PbZr_{0.35}Ti_{0.45}Nb_{0.2}O₃ formation sol-gel solution containing 15% excess Pb. The organic component was removed on a hot plate preheated at 300°C to form an amorphous PZTN thin film having a total thickness of 120 nm. The amorphous PZTN thin film was fired at a firing temperature of 650°C in an oxygen atmosphere to form a PbZr_{0.35}Ti_{0.45}Nb_{0.2}O₃ layer having a thickness of 120 nm.

A platinum gate electrode having a thickness of 100 nm was formed on the ferroelectric layer by using a sputtering method.

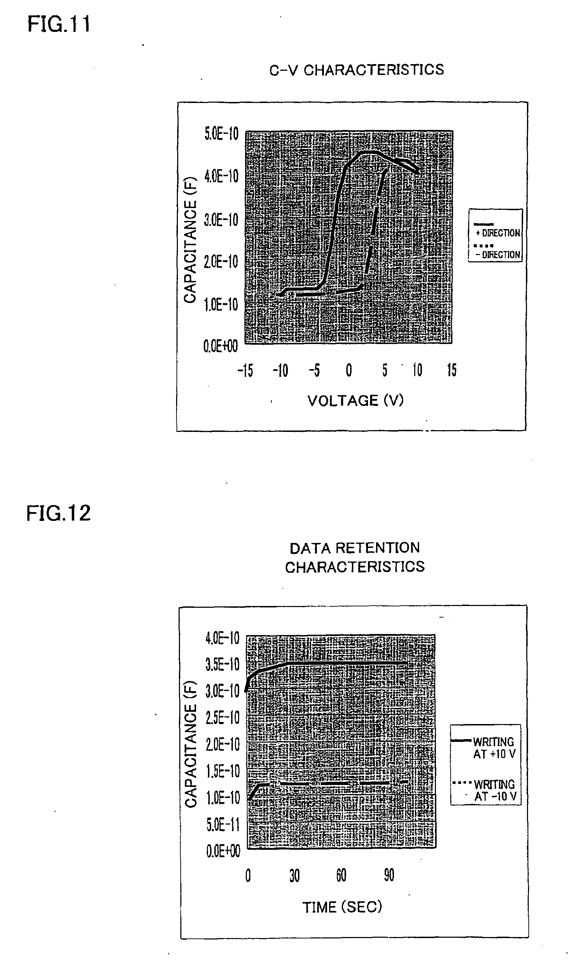

The C-V characteristics of the diode between the gate electrode and the silicon substrate were determined for the resulting sample to obtain the results shown in FIG. 11. As shown in FIG. 11, a C-V hysteresis curve having two threshold values was obtained due to the hysteresis of the ferroelectric. Since two values were obtained at a voltage of 0 V in the C-V hysteresis curve shown in FIG. 11, the retention characteristics of the two values were examined. The data retention characteristics were examined by writing data into the sample by applying an electric charge in the positive direction and measuring a change in the amount of stored charge at 0 V, and then writing data into the sample by applying an electric charge in the negative direction and measuring a change in the amount of stored charge at 0 V. The results are shown in FIG. 12. As shown in FIG. 12, it was confirmed that excellent data retention characteristics are obtained for the two values.

It was confirmed that the transistor type ferroelectric memory of Example 2 has excellent memory characteristics.

### 3.3 Comparative Example 1

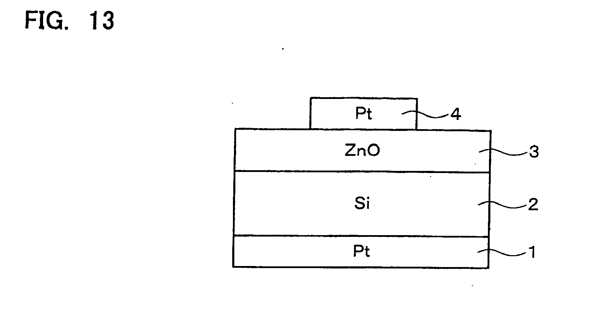

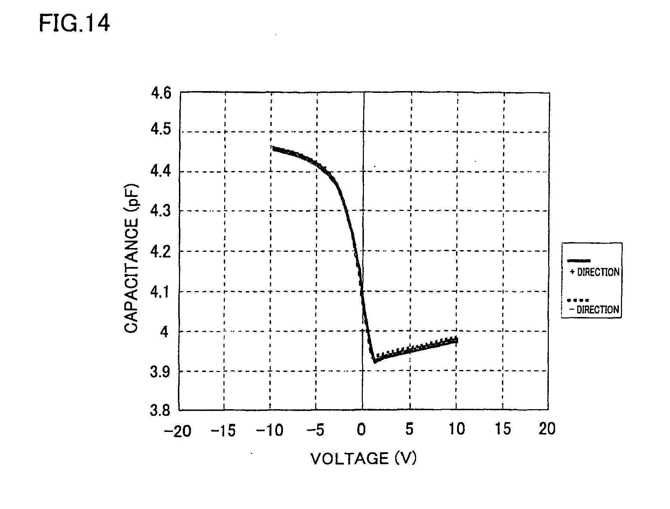

FIG. 13 shows the structure of a sample according to Comparative Example 1. The sample according to Comparative Example 1 has the same layer structure as that of the sample according to Example 1 except that the ferroelectric layer is omitted. The C-V characteristics of the sample according to Comparative Example 1 were determined to obtain the results shown in FIG. 14. As shown in FIG. 14, it was confirmed that the diode formed of the laminate of the group-IV semiconductor layer and the oxide semiconductor layer does not have two threshold values due to the hysteresis of the ferroelectric, differing from the examples.

The invention is not limited to the above described embodiment and thus it can be embodied in various ways within the scope of the invention.

Although only some embodiments of the present invention have been described in detail above, those skilled in the art will readily appreciate that many modifications are possible in the embodiments without materially departing from the novel teachings and advantages of this invention. Accordingly, all such modifications are intended to be included within scope of this invention.

## Claims

1. A transistor type ferroelectric memory, comprising:
a group-IV semiconductor layer;
an oxide semiconductor layer formed over the group-IV semiconductor layer;
a ferroelectric layer formed over the oxide semiconductor layer;
a gate electrode formed over the ferroelectric layer; and
a source region and a drain region formed in the group-IV semiconductor layer.

2. The transistor type ferroelectric memory as defined in claim 1, wherein the group-IV semiconductor layer and the oxide semiconductor layer form a pn junction.

3. The transistor type ferroelectric memory as defined in claim 2, wherein the group-IV semiconductor layer is a p-type, and the oxide semiconductor layer is an n-type.

4. The transistor type ferroelectric memory as defined in claim 2, wherein the group-IV semiconductor layer is a n-type, and the oxide semiconductor layer is an p-type.

5. The transistor type ferroelectric memory as defined in any one of claims 1 to 4, wherein one end of the source region and the drain region is in contact with a part of the oxide semiconductor layer.

6. The transistor type ferroelectric memory as defined in any one of claims 1 to 5, wherein the oxide semiconductor layer of an n-type includes at least one oxide semiconductor selected from ZnO, TiO₂, SnO₂, CdO, MnO, and FeO.

7. The transistor type ferroelectric memory as defined in any one of claims 1 to 6, wherein the oxide semiconductor layer of a p-type includes at least one oxide semiconductor selected from CuAlO₂, NiO, CoO, Cu₂O, MnFe₂O₄, NiFe₂O₄, In₂O₃, MnO, and FeO.

8. The transistor type ferroelectric memory as defined in any one of claims 1 to 7, wherein the ferroelectric layer includes a perovskite oxide or a bismuth layer-structured oxide shown by ABO₃ or (Bi₂O₂)²⁺(Aₘ₋₁BₘO₃ₘ₊₁)²⁻ (wherein A represents at least one element selected from Li, Na, K, Rb, Pb, Ca, Sr, Ba, Bi, La, and Hf, B represents at least one element selected from Ru, Fe, Ti, Zr, Nb, Ta, V, W, and Mo, and m is a natural number of 5 or less), or an oxide having a tungsten bronze structure shown by A_{0.5}BO₃ (tetragonal bronze structure) or A_{0.3}BO₃ (hexagonal bronze structure) (wherein A represents at least one element selected from Li, Na, K, Rb, Cs, Pb, Ca, Sr, Ba, Bi, and La, and B represents at least one element selected from Ru, Fe, Ti, Zr, Nb, Ta, V, W, and Mo).

9. The transistor type ferroelectric memory as defined in any one of claims 1 to 8, wherein the oxide semiconductor layer includes a dopant having a valence differing from a valence of a metal element forming the oxide semiconductor layer and functioning as a donor or an acceptor.

10. A method of manufacturing a transistor type ferroelectric memory, the method comprising:
forming an oxide semiconductor layer over a group-IV semiconductor layer;
forming a ferroelectric layer over the oxide semiconductor layer;
forming a gate electrode over the ferroelectric layer; and
forming a source region and a drain region in the group-IV semiconductor layer.

11. The method of manufacturing a transistor type ferroelectric memory as defined in claim 10, wherein the group-IV semiconductor layer and the oxide semiconductor layer have opposite polarities and form a pn junction.

12. The transistor type ferroelectric memory as defined in claim 11, wherein the group-IV semiconductor layer is a p-type, and the oxide semiconductor layer is an n-type.

13. The transistor type ferroelectric memory as defined in claim 11, wherein the group-IV semiconductor layer is a n-type, and the oxide semiconductor layer is an p-type.

14. The method of manufacturing a transistor type ferroelectric memory as defined in any one of claims 10 to 13, the method comprising:
before forming the oxide semiconductor layer, forming a film of an element having an enthalpy of formation smaller than that of an oxide of an element forming the group-IV semiconductor layer on a surface of the group-IV semiconductor layer under non-oxidizing conditions.
